(19) Europäisches Patentamt / European Patent Office / Office européen des brevets

(11) **EP 1 508 630 B1**

(12) **EUROPEAN PATENT SPECIFICATION**

(45) Date of publication and mention
of the grant of the patent:
**30.07.2008 Bulletin 2008/31**

(51) Int Cl.:
**C23C 16/26** (2006.01)    **B65D 23/02** (2006.01)

(21) Application number: **03730627.1**

(86) International application number:
**PCT/JP2003/006529**

(22) Date of filing: **26.05.2003**

(87) International publication number:
**WO 2003/102263 (11.12.2003 Gazette 2003/50)**

(54) **DEVICE FOR MANUFACTURING DLC FILM-COATED PLASTIC CONTAINER**

VORRICHTUNG ZUR HERSTELLUNG EINES MIT EINEM DLC-FILM BESCHICHTETEN KUNSTSTOFFBEHÄLTERS

APPAREIL DE FABRICATION D'UN CONTENANT EN MATIERE PLASTIQUE REVETU D'UN FILM A DEPOT CDA (CARBONE ANALOGUE AU DIAMANT)

(84) Designated Contracting States:
**AT BE BG CH CY CZ DE DK EE ES FI FR GB GR HU IE IT LI LU MC NL PT RO SE SI SK TR**

(30) Priority: **28.05.2002 JP 2002154700**

(43) Date of publication of application:
**23.02.2005 Bulletin 2005/08**

(73) Proprietor: **KIRIN BEER KABUSHIKI KAISHA**
**Chuo-Ku,**
**Tokyo (JP)**

(72) Inventors:
• **YAMASAKI, Teruyuki,**
**c/o KIRIN BREWERY COMPANY, LTD**
**Tokyo 104-8288 (JP)**
• **SHIRAKURA, Akira,**
**c/o KIRIN BREWERY COMPANY, LTD**
**Tokyo 104-8288 (JP)**
• **ANDO, Hideyasu,**
**c/o KIRIN BREWERY COMPANY, LTD**
**Tokyo 104-8288 (JP)**

(74) Representative: **Bunke, Holger**
**Prinz & Partner GbR**
**Rundfunkplatz 2**
**80335 München (DE)**

(56) References cited:
EP-A1- 0 773 167        JP-A- 2001 031 045
JP-A- 2001 335 946        JP-A- 2002 121 667

**Description**

**TECHNOLOGICAL FIELD**

The present invention is related to an apparatus for manufacturing a plastic container having an inner wall surface coated with a diamond like carbon (DLC) film.

**PRIOR ART TECHNOLOGY**

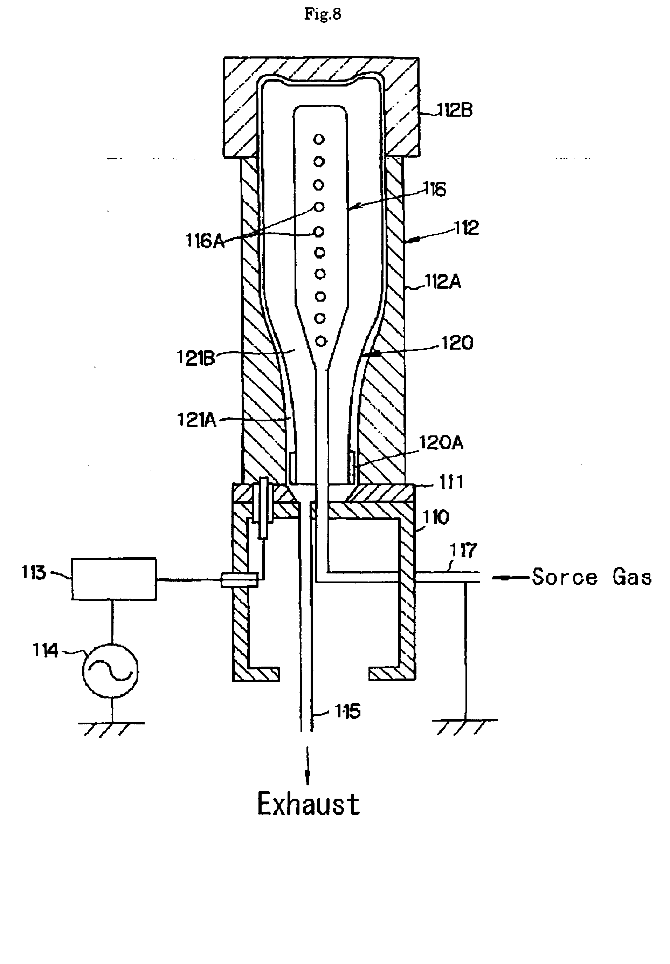

Japanese Laid-Open Patent Application No. HEI 8-53117 discloses an apparatus for manufacturing a carbon film coated plastic container which coats the inner wall surface of the plastic container with a carbon film.
As shown in Fig. 8, this apparatus is equipped with a hollow external electrode 112 which is formed to house a container and includes a space having a shape roughly similar to the external shape of the housed container 120, an insulating member 111 which insulates the external electrode and makes contact with a mouth portion of the container when the container is housed inside the space of the external electrode, a grounded internal electrode 116 which is inserted into the inside of the container housed inside the space of the external electrode from the mouth portion 120A of the container, exhaust means 115 which communicate with the inside of the space of the external electrode to exhaust the inside of the space, supply means 117 which supply a source gas to the inside of the container housed inside the space of the external electrode, and a high frequency power source (RF power source) 114 which is connected to the external electrode. The same apparatus forms a carbon film by a plasma CVD method which generates plasma between the external electrode and the internal electrode.
The grounded internal electrode of the same apparatus is inserted to the inside of the container housed inside the space of the external electrode from the mouth portion of the container. The source gas passes through a gas inlet pipe which also serves as an internal electrode, and after being blown out near the bottom portion inside the container, flows to the body portion, the shoulder portion and the opening, and is then exhausted to the outside of the container and exhausted to the outside of the space. In this way, a potential difference is generated between the internal electrode inserted to the inside of the container and the external electrode arranged around the container by the application of a high frequency to the external electrode, whereby plasma is generated by the excitation of the source gas flowing through the inside of the container.

**SUMMARY OF THE INVENTION**

In the same apparatus, because the internal electrode is inserted to the inside of the container, the distance between the external electrode and the internal electrode is short, and plasma is generated in a stabilized manner inside the container. However, the internal electrode is inserted completely inside the source gas type plasma generating region, and dust created by the decomposition of the source gas adheres to the external surface of the internal electrode. Moreover, in accordance with the fact that the cross-sectional area of a horizontal cross section with respect to the vertical axis of the container becomes smaller suddenly at the container shoulder portion, the source gas flowing through the inside of the container has a higher gas pressure and a higher plasma density at the shoulder portion. In this way, a particularly large amount of dust adheres to the external surface of the internal electrode near the container shoulder portion where the plasma density is high.
Consequently, in the same apparatus, while the number of coating processes is small, dust accumulates on the internal electrode as the coating process in which stabilized plasma is discharged is repeated, and the generation and discharge of plasma becomes unstable due to the lowering of the function of the internal electrode. When this kind of state is reached, it becomes impossible to form a DLC film. Accordingly, in order to prevent incomplete plasma generation and the creation of unstable discharge, after the coating process has been carried out a fixed number of times, a cleaning process which removes the dust adhering to the internal electrode must be carried out. However, in the same apparatus having a structure in which dust adheres to the internal electrode, the cleaning process needs to be carried out frequently, and this makes it impossible to achieve improvement of productivity. From the above facts, in order to obtain stable plasma discharge, the dust adherence problem can not be separated from the requirement for a structure in which there is a mutual close distance between the external electrode and the internal electrode, and there has not been technology which solves both of these simultaneously. Further, it goes without saying that an oxygen barrier property the same as that of a DLC film coated plastic container manufactured by the prior art apparatus having the internal electrode must be secured.
It is an object of the present invention to generate stable plasma and carry out continuous discharge while at the same time preventing the adherence of dust to a mouth side electrode by arranging the mouth side electrode outside the container to face a container side electrode without an electrode being made an internal electrode arranged inside the container. By making these compatible, it is possible to plan a reduction of the cleaning process, and this makes it possible to achieve an improvement of the apparatus.. operation rate.

Further, it is an object of the present invention to provide a mouth side electrode structure which makes the plasma discharge particularly stable. At the same time, it is an object to make the film forming distribution in the circumferential direction of the container side surface more uniform. The reason for this is that the internal electrode of the prior art apparatus is arranged so that the central axis thereof is aligned with the central axis of the container, but in the case where these axes are not aligned due to a subtle machining error, an uneven distribution of plasma density is created in the circumferential direction of the container side surface, and there are minute film irregularities (color irregularities) in the circumferential direction of the container side surface.

Further, the present invention provides an arrangement place preferred for the mouth side electrode or an annular end or a tubular end in order to make the plasma discharge particularly stable.

Further, it is an object of the present invention to provide an optimum source gas inlet pipe which does not hinder plasma generation and continued discharge and is not damaged even inside the plasma region.

It is an object of the present invention to form a DLC film uniformly by arranging the source gas inlet pipe to be freely inserted to and removed from a depth which reaches the bottom portion from the body portion of the container, and forming a source gas flow without stagnation from the blowout hole of the source gas inlet pipe to the exhaust port to spread the source gas over the entire inner wall surface of the container.

It is an object of the present invention to ensure that the source gas is uniformly spread inside the container and plan the prevention of the adherence of dust to the source gas inlet pipe by providing source gas inlet pipe insertion/removal means. Namely, because a structure is formed in which dust does not adhere to the mouth side electrode, the introduction of the source gas inlet pipe insertion/removal means makes it unnecessary to carry out the source gas inlet pipe cleaning process.

It is an object of the present invention to provide an apparatus for manufacturing a DLC film coated plastic container which is a beverage container.

In order to prevent the plasma generation and discharge continuity from becoming unstable due to dust adhering to an internal electrode, the present inventors discovered that it is possible to solve the problems described above by providing a mouth side electrode which faces the container side electrode outside the container without providing an internal electrode inside the container. Namely, the apparatus for manufacturing a DLC film coated plastic container according to the present invention includes a container side electrode which forms one portion of a pressure-reducing chamber which houses a plastic container, and a mouth electrode arranged above the opening of said plastic container, wherein said container side electrode and said mouth side electrode are made to face each other via an insulating body which forms a portion of said pressure-reducing chamber, source gas supply means which supply a source gas that is converted to plasma for coating the inner wall surface of said plastic container with a diamond like carbon (DLC) film includes a source gas inlet pipe formed from an insulating material provided in said pressure-reducing chamber to introduce said source gas supplied to said pressure-reducing chamber to the inside of said plastic container, exhaust means which exhaust gas inside said pressure-reducing chamber from above the opening of said plastic container are provided, and high frequency supply means which supply a high frequency is connected to said container side electrode.

In the apparatus for manufacturing a DLC film coated plastic container described in Claim 1, preferably said mouth side electrode is equipped with an annular portion having an inner hole diameter roughly the same as the opening diameter of said plastic container, and the opening of the end of said annular portion is aligned coaxially with respect to the opening of said plastic container and arranged near the opening of said plastic container.

In the apparatus for manufacturing a DLC film coated plastic container described in Claim 1, preferably said mouth side electrode is formed to have a tubular portion which hangs down from the top portion of said pressure-reducing chamber to a position above the opening of said plastic container, said source gas supplied by said source gas supply means is introduced inside said tubular portion, and the end of said tubular portion is connected to said source gas inlet pipe.

In the apparatus for manufacturing a DLC film coated plastic container described in Claim 1, 2 or 3, preferably the mouth side electrode described in Claim 1, the end of the annular portion described in Claim 2 or the end of the tubular portion described in Claim 3 makes contact with a gas flow formed from a position near the opening of said plastic container to an exhaust port of said pressure-reducing chamber by the operation of said exhaust means.

In the apparatus for manufacturing a DLC film coated plastic container described in Claim 1, 2, 3 or 4, preferably said source gas inlet pipe is formed from a resin material such as fluororesin or the like having an insulating property and heat resistance sufficient to endure plasma or is formed from a ceramic material such as alumina or the like having an insulating property.

In the apparatus for manufacturing a DLC film coated plastic container described in Claim 1, 2, 3, 4 or 5, preferably said source gas inlet pipe is arranged to be freely inserted to and removed from a deep position reaching the bottom portion from the body portion through the opening of said plastic container.

The apparatus for manufacturing a DLC film coated plastic container described in Claim 1, 2, 3, 4, 5 or 6 is preferably provided with source gas inlet pipe insertion/removal means which places said source gas inlet pipe in an inserted state inside said plastic container when said source gas is introduced, and places said source gas inlet pipe in a removed state from said plastic container when plasma is generated.

In the apparatus for manufacturing a DLC film coated plastic container described in Claim 1, 2, 3, 4, 5, 6 or 7, preferably said plastic container is a beverage container.

The invention described in Claim 1 makes it possible to provide a manufacturing apparatus which carries out plasma discharge in a stable manner and makes it very difficult for dust to adhere to the electrode. By making these contrary facts compatible, a reduction of the cleaning process can be planned, and an improvement of the apparatus operation rate is achieved. Of course, an oxygen barrier property the same as that of the DLC film coated plastic container manufactured by the prior art type apparatus having an internal electrode is secured. The invention described in Claim 2 or 3 makes it possible to provide an apparatus in which the plasma discharge is made particularly stable, and at the same time makes it possible to form a more uniform film forming distribution in the circumferential direction of the container side surface. In particular, it was possible to improve color irregularities in the circumferential direction of the container side surface at the neck portion. The invention described in Claim 4 makes it possible to provide an apparatus which can generate plasma and continue discharge in a stable manner. In the invention described in Claim 5, the source gas inlet pipe does not hinder plasma generation and continued discharge and is not damaged even inside the plasma region. The invention described in Claim 6 makes it possible to spread the source gas over the entire inner wall surface of the container to form a uniform DLC film. The invention described in Claim 7 makes it possible to prevent the adherence of dust to the source gas inlet pipe while ensuring that the source gas is spread uniformly inside the container, and makes the process of cleaning the source gas inlet pipe unnecessary. Because there is no dust contamination adhering to an internal electrode, the present invention is particularly suited to beverage containers.

**BRIEF DESCRIPTION OF THE DRAWINGS**

Fig. 1 is a schematic drawing which shows one embodiment of the present manufacturing apparatus.

Fig. 2 is a schematic drawing of the case where a gap is provided between the outer wall of the container and the inner wall of the container side electrode in the apparatus of Fig. 1.

Fig. 3 is a schematic drawing which shows another embodiment of the present manufacturing apparatus.

Fig. 4 is a schematic drawing of the case where a gap is provided between the outer wall of the container and the inner wall of the container side electrode in the apparatus of Fig. 3.

Fig. 5 is a conceptual drawing which shows the flow of gas from the container opening to the exhaust port in the apparatus of Fig. 3.

Fig. 6 is a schematic drawing which shows another embodiment of a source gas inlet pipe in the apparatus of Fig. 1.

Fig. 7 is a schematic drawing which shows another embodiment of a source gas inlet pipe in the apparatus of Fig. 3.

Fig. 8 is a drawing which shows a conceptual drawing of a prior art apparatus for manufacturing a DLC film coated plastic container.

Fig. 9 shows pictures showing the dust adherence state on the tubular portion (SUS splicing means) of the mouth side electrode.

Fig. 10 shows pictures showing a comparison of a DLC film coated plastic container in the case where film formation is repeated 15 times in the same container under the conditions of Specific Embodiment 1 and a DLC film coated plastic container in the case where film formation is repeated 15 times in the same container under the conditions of Comparative Example 1.

Fig. 11 is a drawing which shows the names of each part of a beverage container.

Fig. 12 is a graph in which the color irregularities of Specific Embodiment 1 and Comparative Example 1 in the circumferential direction at the container neck portion are shown by b* values.

The meaning of the symbols is as follows. 1 shows an upper electrode, 2 shows a lower electrode, 3 shows a container side electrode, 4 shows an insulating body, 5 shows a mouth side electrode, 5a shows a tubular body, 5b shows a tubular body end, 6 shows a pressure-reducing chamber, 7 shows a plastic container, 8 shows an O-ring, 9 shows a source gas inlet pipe, 9a shows a blowout hole, 10 shows an opening, 11 shows an annular portion of the mouth side electrode, 12 shows a matching box, 13 shows a high frequency power source, 14 shows high frequency supply means, 16 shows a pipeline, 17 shows a source gas generating source, 18 shows source gas supply means, 19 shows a vacuum valve, 20 shows an exhaust pump, 21 shows exhaust means, and 23 shows an exhaust port.

## PREFERRED EMBODIMENTS OF THE INVENTION

Detailed descriptions showing embodiments of the present invention are given below, but it should not be interpreted that the present invention is limited to these descriptions.

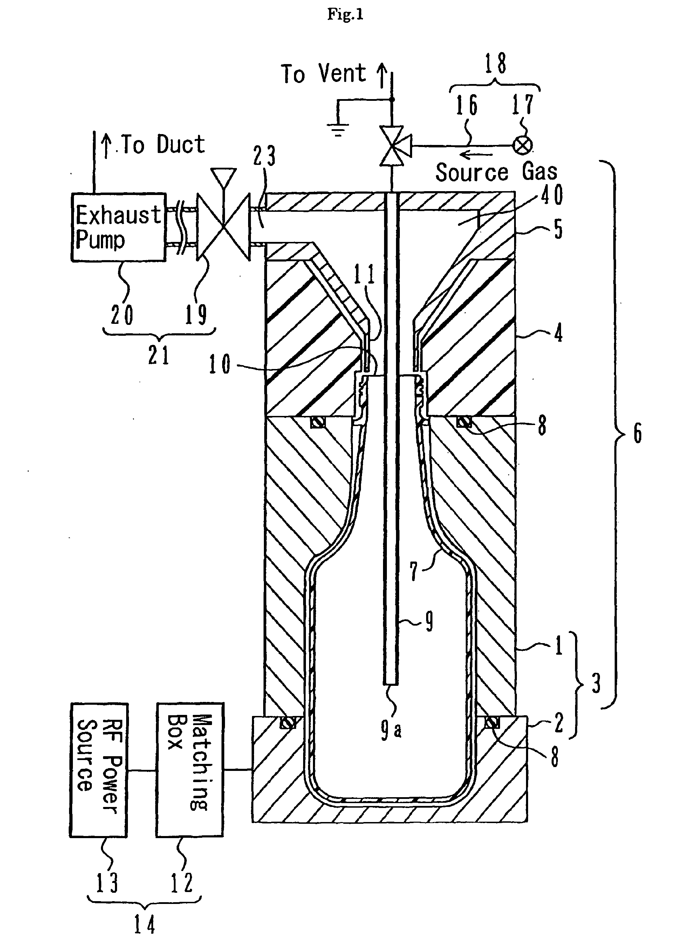

First, the structure of an apparatus for manufacturing a DLC film coated plastic container according to the present invention will be described with reference to Figs. 1 - 7. Further, the same symbols are used for the same members in the drawings. Fig. 1 is a schematic drawing of the present manufacturing apparatus. Figs. 1 - 7 are cross-sectional schematic drawings of a pressure-reducing chamber. As shown in Fig. 1, the manufacturing apparatus has a container side electrode 3 which forms one portion of a pressure-reducing chamber 6 which houses a plastic container 7, and a mouth side electrode 5 which is arranged above an opening 10 of the plastic container 7, wherein the container side electrode 3 and the mouth side electrode 5 are made to face each other via an insulating body 4 which forms a portion of the pressure-reducing chamber 6, source gas supply means 18 which supply a source gas that is converted to plasma for coating the inner wall surface of the plastic container 7 with a DLC film includes a source gas inlet pipe 9 formed from an insulating material provided in the pressure-reducing chamber 6 to introduce the source gas supplied to the pressure-reducing chamber 6 to the inside of the plastic container 7, exhaust means 21 which exhaust gas inside the pressure-reducing chamber 6 from above the opening 10 of the plastic container 7 are provided, and high frequency supply means 14 which supply a high frequency is connected to the container side electrode 3.

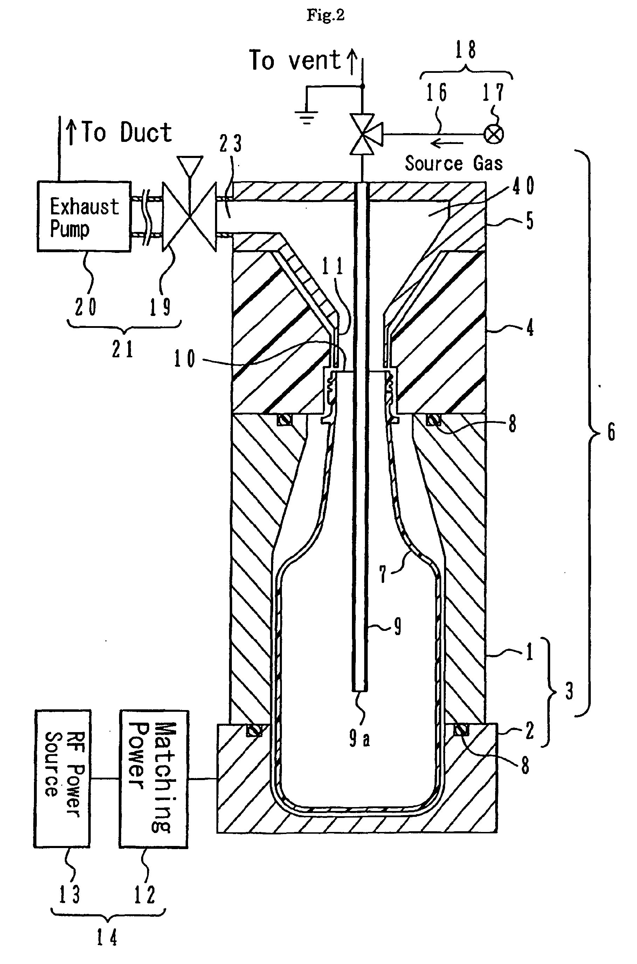

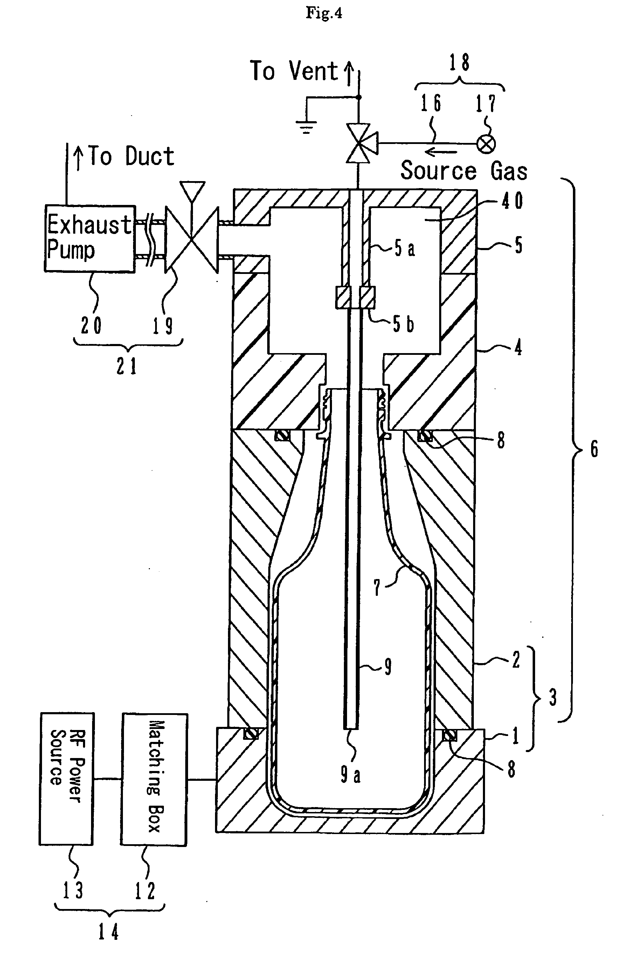

The container side electrode 3 is constructed from an upper electrode 1 and a lower electrode 2 which can be attached to and removed from the upper electrode 1. An O-ring 8 is arranged between the upper electrode 1 and the lower electrode 2 to ensure airtightness. The upper electrode 1 and the lower electrode 2 form a conducting state so as to form one body as a container side electrode. The container side electrode 3 has a structure that is divided into the upper electrode 1 and the lower electrode 2 to provide a housing opening for housing the plastic container 7 inside the container side electrode 3. In Fig. 1, the container side electrode 3 is divided to form the two upper and lower portions, but it may be divided to form three upper, middle and lower portions for housing the container, or it may be divided vertically. The container side electrode 3 shown in Fig. 1 is given a shape which houses the container excluding the mouth portion of the container. The reason for this is that it reduces the formation of a DLC film on the inner wall surface of the mouth portion. Accordingly, in the case where a DLC film is formed on the inner wall surface of the mouth portion, a shape may be formed to house the entire container. Further, in order to adjust the film forming region, a shape may be formed to house the container excluding the mouth portion of the container and one portion of the neck portion. Further, as for the inner wall of the space housing the container, the container side electrode 3 in Fig. 1 is given a similar shape so that the outer wall of the container and the inner wall of the space are almost touching, but so long as it is possible to apply a suitable self bias voltage to each part of the container inner wall when a high frequency is supplied to the container side electrode, as shown in Fig. 2 or Fig. 4, the container side electrode 3 does not always need to be given a similar shape. In Fig. 2 and Fig. 4, a gap is provided between the outer wall of the container neck portion and the inner wall of the container side electrode.

The mouth side electrode 5 is an electrode which faces the container side electrode 3. Accordingly, because an insulating state needs to be formed between the mouth side electrode 5 and the container side electrode 3, the insulating body 4 is provided between these electrodes. The mouth side electrode 5 is arranged so as to be positioned above the opening 10 of the container. At this time, the entire mouth side electrode 5 or one portion thereof is preferably arranged near (directly above) the opening 10. This is because the distance to the container side electrode 3 is made closer. Further, the shape of the mouth side electrode 5 can be formed freely, but as shown in Fig. 1, the mouth side electrode is preferably equipped with an annular portion 11 having an inner hole diameter roughly the same as the opening diameter of the plastic container 7. The mouth side electrode is preferably formed so that the opening of the end of the annular portion 11 is aligned coaxially with respect to the opening 10 of the plastic container 7 and arranged near the opening 10 of the plastic container 7. An annular portion is formed because it makes it possible to prevent an increase in exhaust resistance due to the mouth side electrode. Further, the mouth side electrode 5 is preferably grounded.

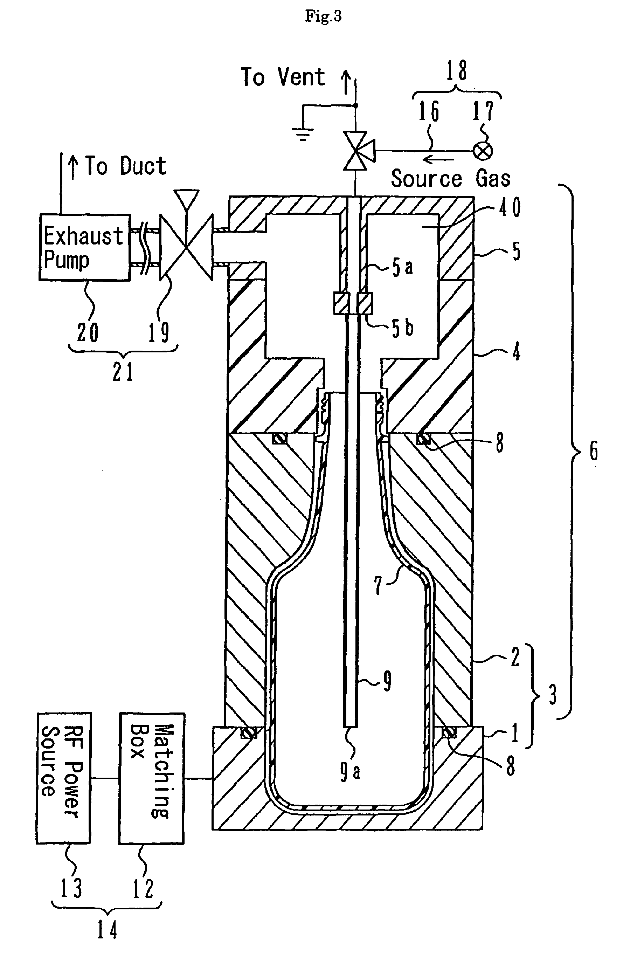

In the present invention, as shown in Fig. 3, the mouth side electrode 5 may be formed to have a tubular portion 5a which hangs down from the top portion of the pressure-reducing chamber to a position above the opening 10 of the plastic container 7, wherein the source gas supplied by the source gas supply means 18 is introduced inside the tubular portion 5a, and an end 5b of the tubular portion 5a is connected to the source gas inlet pipe 9. At this time, the end 5b of the tubular portion 5a is preferably arranged near (directly above) the opening 10 of the plastic container 7. In the case of Fig. 3, the end 5b forms splicing means for connecting the tubular portion and the source gas inlet pipe. By forming this kind of structure, it is possible to make the tubular portion 5a function as one portion of the source gas inlet pipe as the mouth side electrode is brought near the opening 10. Further, in the same way as was described for the arrangement of the annular portion 11, the central axis of the tubular portion 5a is preferably aligned with the central axis of the container. This prevents eccentricity of plasma generated inside the container, and makes the plasma intensity uniform in the circumferential direction of the container.

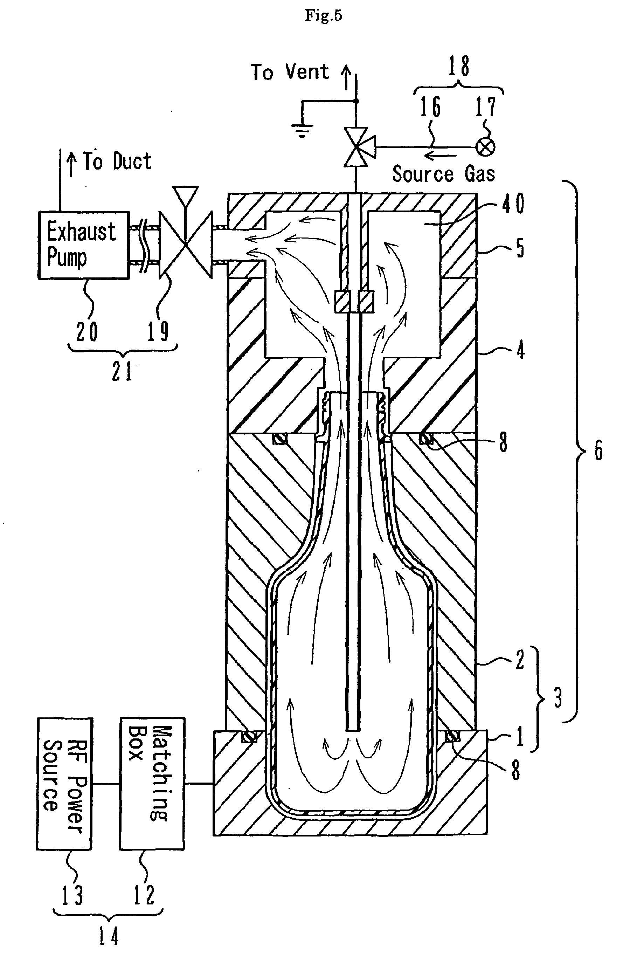

The mouth side electrode or the end of the annular portion 11 of Fig. 1 or the end of the tubular portion of Fig. 3 preferably makes contact with the gas flow formed from a position near the opening 10 of the plastic container 7 to an exhaust port 23 of the pressure-reducing chamber 6 by the operation of the exhaust means 21. As shown by the arrow in Fig. 5, this gas flow is believed to be formed inside the container and inside the space 40. By having the mouth side electrode or the end of the tubular portion make contact with this gas flow, it is possible to generate plasma easily and stabilize discharge. As for the generation of plasma and the stabilization of discharge in this way, the present inventors believe this is because the gas flow converted to plasma forms a conducting body. In this regard, the space 40 is preferably given a shape that does not form a gas flow and does not create so-called stagnation, and by giving the space 40 a shape that does not create stagnation, it becomes possible to expand the possible arrangement region of the mouth side electrode or the end of the tubular portion.

Compared with a prior art apparatus like that of Fig. 8 in which an internal electrode is inserted to the inside of the container, in the present apparatus, a mouth side electrode is arranged above the opening of the container as a facing electrode of the container side electrode. The present invention makes it possible to generate plasma and continue discharge by providing the mouth side electrode above the opening of the container without an internal electrode arranged inside the container. Even when the distance between the mouth side electrode and the container side electrode is long, plasma is generated if the gas that is to be converted to plasma exists as a continuous body at a reduced pressure. In this regard, by arranging the mouth side electrode above the opening where the source gas type plasma which has just been exhausted from the container opening has a high gas pressure and a high plasma density, it is possible to continue plasma discharge and raise the discharge uniformity particularly in the neck portion. Because the mouth side electrode does not lie completely inside the plasma region, there is little adherence of dust, and in contrast with the prior art apparatus in which the discharge becomes unstable at approximately 1,000 times, in the apparatus of the present invention, the generation of plasma and the continuity of discharge was still stable even after discharge was carried out 20,000 times. Accordingly, it is possible to extend the interval for carrying out an electrode cleaning process, and this makes it possible to improve the operation rate of the apparatus.

Further, by giving the container side electrode the annular portion 11 of Fig. 1 or the tubular portion of Fig. 3, it is possible to mitigate mechanical errors of the apparatus and reduce distribution irregularities of the plasma discharge inside the plastic container in the circumferential direction of the container side surface, and this makes it possible to reduce irregularities (film thickness irregularities and coloration irregularities) of the film distribution particularly at the neck portion.

Further, the material of the container side electrode and the mouth side electrode is preferably stainless steel (SUS) or aluminum.

The insulating body 4 serves the role of forming an insulating state between the mouth side electrode 5 and the container side electrode 3, and also serves the role of forming one portion of the pressure-reducing chamber 6. The insulating body is formed by a fluororesin, for example. The pressure-reducing chamber 6 is formed by assembling the container side electrode 3, the insulating body 4 and the mouth side electrode 5 to be mutually airtight. Namely, an O-ring is arranged between the container side electrode 3 and the insulating body 4 to ensure airtightness. Further, an O-ring (not shown in the drawings) is also arranged between the insulating body 4 and the mouth side electrode 5 to ensure airtightness. In the apparatus of Fig. 1, a structure is formed in which the mouth side electrode 5 is provided above the insulating body 4, but when the mouth side electrode 5 forms a facing electrode that faces the container side electrode 3, because the size thereof can be freely set, the size of the member formed from the insulating body 4 and the mouth side electrode 5 shown in Fig. 1 may be fixed, and the insulating body may be formed large with the mouth side electrode being made smaller by just that size portion. Alternatively, the insulating body may be formed small enough to serve the role of only a rough insulator with the mouth side electrode being made larger by just that size portion. A space 40 is formed inside the member formed from the insulating body 4 and the mouth side electrode 5, and the space 40 together with the space inside the plastic container 7 form a pressure-reducing space. The pressure-reducing chamber 6 forms this pressure-reducing space.

The source gas inlet pipe 9 is formed from an insulating material to have a hollow (cylindrical) shape. The source gas inlet pipe 9 is provided inside the pressure-reducing chamber 6 so as to be arranged inside the plastic container 7 by being freely inserted and removed through the opening 10 of the container. At this time, the source gas inlet pipe 9 is supported on the pressure-reducing chamber 6. As for the method of support, the source gas inlet pipe 9 can be supported on the mouth side electrode 5 as shown in Fig. 1, for example, or the source gas inlet pipe 9 can be supported on the tubular portion 5a via the splicing means as shown in Fig. 3. Further, one blowout hole (9a) which communicates the inside and the outside of the source gas inlet pipe 9 is formed on the lower end of the source gas inlet pipe 9. Further, instead of providing a blowout hole at the lower end, a plurality of blowout holes (not shown in the drawings) may be formed to pass through the inside and the outside of the source gas inlet pipe 9 in radial directions. The source gas inlet pipe 9 is connected to the end of a pipeline of the source gas supply means 18 which communicates with the inside of the source gas inlet pipe 9. Further, the apparatus is constructed so that the source gas sent into the inside of the source gas inlet pipe 9 via the pipeline can be blown into the inside of the plastic container 7 via the blowout hole 9a. The reason the source gas inlet pipe 9 is formed from an insulating material is because this reduces the adherence of source gas type dust to the external surface of the source gas inlet pipe 9. In the prior art, because a source gas inlet pipe like that of Fig. 8 is also used as an internal electrode, most of the ions of the source gas converted to plasma collide with the container inner wall surface, but one portion of the source gas ions near the internal electrode makes contact with the internal electrode, and this forms source gas type dust which adheres to the internal electrode. This dust is an insulating substance which insulates the internal electrode and destabilizes the plasma discharge. In the present invention, because the source gas inlet pipe is formed from an insulating material, the adherence of source gas type dust is reduced and there is no destabilization of the plasma discharge even when dust adheres, for example.

The source gas inlet pipe 9 is preferably formed from a resin material having an insulating property and heat resistance sufficient to endure plasma. In this regard, fluororesin, polyamide, polyimide, and polyether ether ketone can be used as examples of a resin material. Alternatively, the source gas inlet pipe 9 is preferably formed from a ceramic material having an insulating property. Alumina, zirconia, titania, silica and quartz glass can be used as examples of a ceramic material.

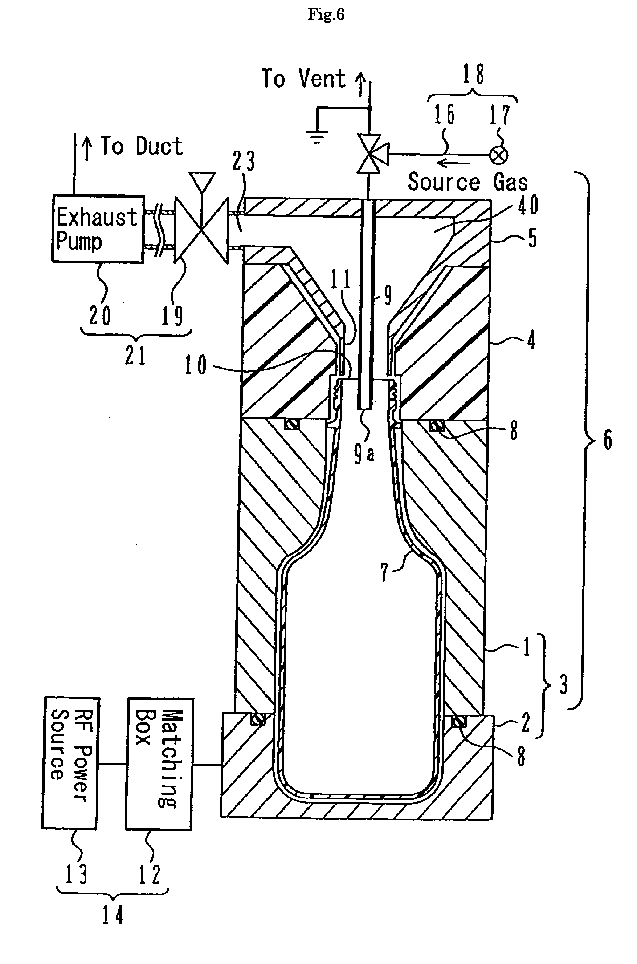

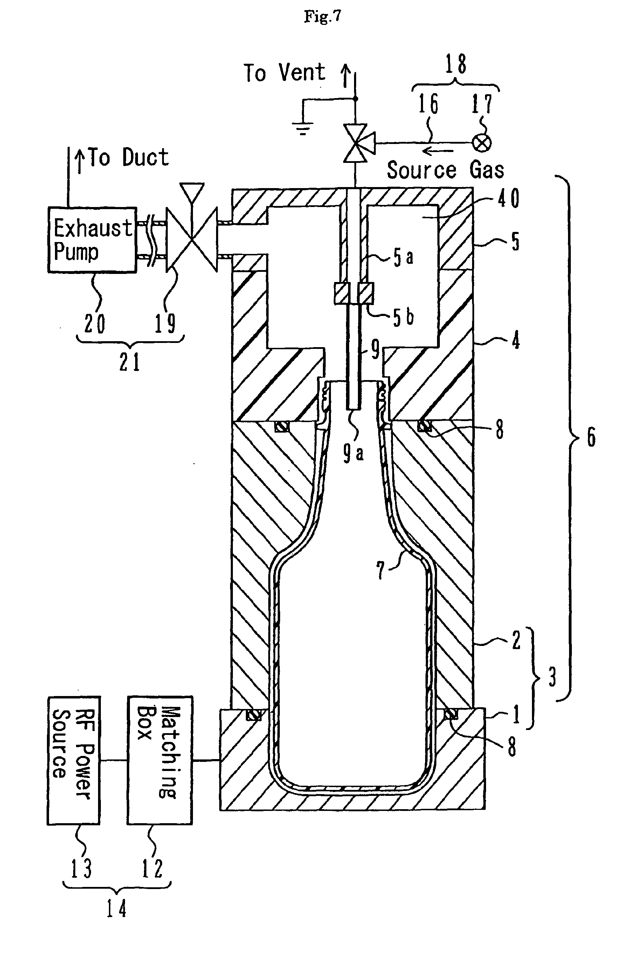

Even in the case where the tip portion of the source gas inlet pipe 9 is inserted through the opening of the plastic container to a position near the mouth portion as shown in Fig. 6 or Fig. 7, it becomes possible to supply source gas to the entire inside of the plastic container. The strong point of this method is that there is almost no adherence of dust due to the fact that the gas inlet pipe made of fluororesin or the like does not exist in the portion where the plasma concentration is highest, namely, the portion where it is easiest for film-like dust to adhere. The amount of dust adherence is reduced significantly more than that of Specific Embodiment 3 of Table 2. However, when considering the oxygen barrier property under the same film forming conditions, the tip of the source gas inlet pipe is more preferably arranged to be freely inserted to and removed from a deep position reaching the bottom portion from the body portion through the opening of the plastic container as shown in Figs. 1 ~ 4. The reason for this is that it makes it possible to form a turbulence-free source gas flow from the bottom portion of the container to the opening as shown in Fig. 5, and this makes it possible to form a DLC film more uniformly on the inner wall surface of the container.

Further, in the apparatus of the present invention, the source gas inlet pipe is inserted inside the plastic container at the time a source gas is introduced, and source gas inlet pipe insertion/removal means (not shown in the drawings) may be provided to place the source gas inlet pipe in a removed state from the plastic container at the time plasma is generated. There is no adherence of dust because the source gas inlet pipe insertion/removal means make it possible to distribute source gas and form a DLC film over the entire inside of the plastic container, and make it possible to remove the source gas inlet pipe from the plasma region at the time a film is formed. Further, in the case where source gas inlet pipe insertion/removal means are provided to place the source gas inlet pipe in a removed state from the plastic container when plasma is generated, a valve (shutter) (not shown in the drawings) which can be freely opened and closed for the purpose of closing the portion near the opening may be provided.

Further, dust incineration means (not shown in the drawings) may be provided to incinerate dust adhering to a ceramic material type source gas inlet pipe 9 in the present apparatus. Two or more source gas inlet pipes which can be arranged in an alternating manner are prepared, and after a film is formed a prescribed number of times, the arrangement of the source gas inlet pipes are switched, and the dust adhering to the source gas inlet pipe in standby is incinerated by operating the dust incineration means.

The source gas supply means 18 introduces the source gas supplied from a source gas generating source 17 to the inside of the plastic container 7. Namely, one side of a pipeline 16 is connected to the mouth side electrode 5 or the insulating body 4, and the other side of the pipeline 16 is connected to one side of a mass flow controller (not shown in the drawings) via a vacuum valve (not shown in the drawings). The other side of the mass flow controller is connected to the source gas generating source 17 via a pipeline. The source gas generating source 17 generates a hydrocarbon gas or the like such as acetylene or the like.

Aliphatic hydrocarbons, aromatic hydrocarbons, oxygen-containing hydrocarbons, nitrogen-containing hydrocarbons and the like which form a gas or liquid at room temperature are used as a source gas. In particular, benzene, toluene, o-xylene, m-xylene, p-xylene, cyclohexane and the like having a carbon number of 6 or higher are preferred. Ethylene type hydrocarbons and acetylene type hydrocarbons represent examples of aliphatic hydrocarbons. These materials may be used separately or as a gas mixture or two or more types. Further, these gases may be used in a way in which they are diluted by a noble gas such as argon or helium. Further, in the case where a silicon-containing DLC film is formed, a Si-containing hydrocarbon type gas is used.

The DLC film in the present invention refers to an amorphous carbon film containing sp$^3$ bonding which is a carbon film that is also called an i-carbon film or a hydrogenated amorphous carbon film (a-CH). The amount of hydrogen contained in the DLC film which sets the film quality from hardness to softness (polymer like) is in the range from 0 atom % to 70 atom %.

The exhaust means 21 is constructed from a vacuum valve 19 and an exhaust pump 20 as well as a pipeline that connects these. The space 40 formed inside the member formed from the insulating body 4 and the mouth side electrode 5 is connected to one side of an exhaust pipeline. For example, in Fig. 1, an exhaust pipeline is connected to the exhaust port 23 provided in the upper left portion of the mouth side electrode 5. The other side of the exhaust pipeline is connected to the exhaust pump 20 via the vacuum valve 19. The exhaust pump 20 is connected to an exhaust duct (not shown in the drawings). By operating the exhaust means 21, pressure is reduced in a pressure-reducing space formed from the space 40 inside the pressure-reducing chamber 6 and the space inside the container.

The high frequency supply means 14 is formed from a matching box 12 which is connected to the container side electrode 3, and a high frequency power source 13 which supplies a high frequency to the matching box 12. The matching box 12 is connected to the output side of the high frequency power source 13. In Fig. 1, the high frequency supply means 14 is connected to the lower electrode 2, but it may also be connected to the upper electrode 1. Further, the high frequency power source 13 is grounded. The high frequency power source 13 generates a high frequency voltage between itself and the ground potential, and in this way a high frequency voltage is applied between the container side electrode 3 and the mouth side electrode 5. In this way, the source gas inside the plastic container 7 is converted to plasma. The frequency of the high frequency power source is 100 kHz ~ 1,000 MHz, and the industrial frequency of 13.56 MHz is used, for example.

The container according to the present invention includes a container that uses a cover or a stopper or is sealed, or a container used in an open state that does not use these. The size of the opening is determined in accordance with the contents. The plastic container includes a plastic container having a moderate stiffness and a prescribed thickness, and a plastic container formed from a sheet material that does not have stiffness. The substance that is filled into the plastic container according to the present invention can be a beverage such as a carbonated beverage or a fruit juice beverage or a soft drink or the like, as well as a medicine, an agricultural chemical, or a dried food which hates moisture absorption. Further, the container may be either a returnable container or a one-way container.

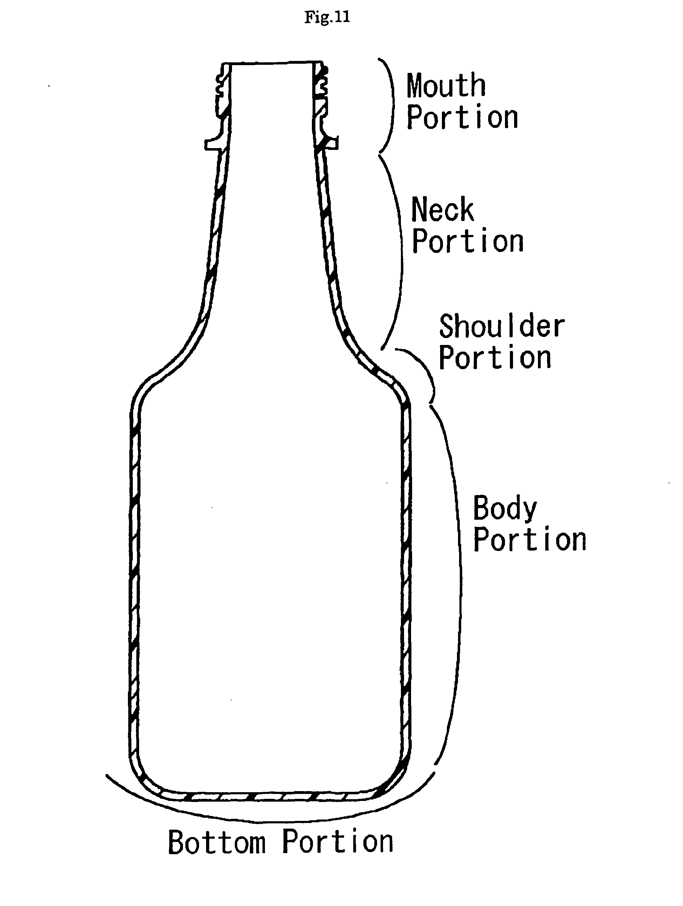

Further, in the present invention, each part of a beverage container or a container having a shape similar to this is named as shown in Fig. 11.

The resin used when forming the plastic container 7 of the present invention can be polyethylene terephthalate (PET) resin, polybutylene terephthalate resin, polyethylene naphthalate resin, polyethylene resin, polypropylene (PP) resin, cycloolefin copolymer (COC, annular olefin copolymer) resin, ionomer resin, poly-4-methylpentene-1 resin, polymethyl methacrylate resin, polystyrene resin, ethylene-vinyl alcohol copolymer resin, acrylonitrile resin, polyvinyl chloride resin, polyvinylidene chloride resin, polyamide resin, polyamide-imide resin, polyacetal resin, polycarbonate resin, polysulfone resin, or ethylene tetrafluoride, acrylonitrile-styrene resin, acrylonitrile-butadiene-styrene resin. Of these, PET is particularly preferred.

Next, with reference to Fig. 1, a description will be given for a process in the case where a DLC film is formed on the inner wall surface of the plastic container 7 using the present apparatus.

First, a vent (not shown in the drawings) is opened, and the inside of the pressure-reducing chamber 6 is opened to the atmosphere. In this way, air enters the space 40 and the space inside the plastic container 7, and the inside of the pressure-reducing chamber 6 reaches atmospheric pressure. Next, the lower electrode 2 of the container side electrode 3 is removed from the upper electrode 1, and the plastic container 7 is set so that the bottom portion thereof makes contact with the top surface of the lower electrode 2. A PET bottle is used as the plastic container 7, for example. Then, by raising the lower electrode 2, the plastic container 7 is housed in the pressure-reducing chamber 6. At this time, the source gas inlet pipe 9 provided in the pressure-reducing chamber 6 is passed through the opening 10 of the plastic container 7 and inserted inside the plastic container 7, and the mouth side electrode 5 is arranged above the opening of the container. Further, the container side electrode 3 is sealed by the O-ring 8.

When the lower electrode 2 is raised to a prescribed position and the pressure-reducing chamber 6 is sealed, a state is formed in which the periphery of the plastic container 7 makes contact with the inner surface of the lower electrode 2 and the upper electrode 1. Next, after closing the vent, the exhaust means 21 is operated to exhaust the air inside the pressure-reducing chamber 6 through the exhaust port 23. Then, the pressure inside the pressure-reducing chamber 6 is reduced until a required vacuum level of 4 Pa or lower, for example, is reached. This is because there will be too many impurities inside the container when the vacuum level is allowed to exceed 4 Pa. Then, the source gas (e.g., a carbon source gas such as an aliphatic hydrocarbon, an aromatic hydrocarbon or the like) sent from the source gas supply means 18 which controls the flow rate is introduced inside the plastic container 7 from the blowout hole 9a of the source gas inlet pipe 9. The source gas supply rate is preferably 20 ~ 50 ml/min.

After the concentration of the source gas becomes fixed and a prescribed film forming pressure is stabilized at 7 - 22 Pa, for example, by balancing the controlled gas flow rate and the exhaust capacity, a high frequency voltage is applied between the mouth side electrode 5 and the container side electrode 3 via the matching unit 12 by operating the high frequency power source 13, and source gas type plasma is generated inside the plastic container 7. At this time, the matching unit 12 matches the impedance of the container side electrode 3 and the mouth side electrode 5 by the inductance L and the capacitance C. In this way, a DLC film is formed on the inner wall surface of the plastic container 7. Further, the output (e.g., 13.56 MHz) of the high frequency power source 13 is approximately 200 ∼ 500 W.

Namely, the formation of a DLC film on the inner wall surface of the plastic container 7 is carried out by a plasma CVD method. Electrons accumulate on the inner wall surface of the container by the high frequency applied between the container side electrode 3 and the mouth side electrode 5, and this creates a prescribed potential drop. In this way, plasma is generated, and the carbon and the hydrogen of the hydrocarbon which is the source gas present in the plasma are both ionized to positive. Then, these ions randomly collide with the inner wall surface of the plastic container 7. At this time, there is bonding between adjacent carbon atoms and between carbon atoms and hydrogen atoms, and the release of temporarily bonded hydrogen atoms (a spattering effect) occurs. When the above processes are carried out, a very fine DLC film is formed on the inner wall surface of the container 7. By applying a moderate high frequency output, plasma discharge is continued between the container side electrode 3 and the mouth side electrode 5. The film formation time is several seconds which is short.

Further, after the concentration of source gas becomes fixed and stabilization at a prescribed film formation pressure is achieved by balancing the controlled gas flow rate and the exhaust capacity, the source gas inlet pipe may be removed from the plastic container before plasma generation by operating the source gas inlet pipe insertion/removal means, and then source gas type plasma may be generated inside the plastic container 7 by applying a high frequency voltage between the mouth side electrode 5 and the container side electrode 3 via the matching unit 12 by operating the high frequency power source 13. At this time, because the source gas inlet pipe is not inside the plastic container during plasma discharge, the adherence of dust can be suppressed more.

Next, the RF output from the high frequency power source 13 is stopped, and the supply of source gas is stopped. Then, the hydrocarbon gas inside the pressure-reducing chamber 6 is exhausted by the exhaust pump 20 until a pressure of 2 Pa or lower is reached. Then, the vacuum valve 19 is closed, and the exhaust pump 20 is stopped. Then, the vent (not shown in the drawings) is opened to open the inside of the pressure-reducing chamber 6 to the atmosphere, and by repeating the above-described film formation method, a DLC film is formed on the inside of the next plastic container.

In the present embodiment, a PET bottle for beverages was used as the container having a thin film formed on the inside, but it is also possible to use containers used for other uses.

In the present embodiment, an apparatus of the type in which the opening of the container faces upward is shown, but it is also possible to form a pressure-reducing chamber in which the top and bottom are reversed.

Further, in the present embodiment, a DLC film is the thin film formed by the manufacturing apparatus, but it is also possible to use the film forming apparatus described above when forming a Si-containing DLC film or other thin film.

The film thickness of the DLC film is formed to be 10 ∼ 80 nm.

<u>SPECIFIC EMBODIMENTS</u>

The plastic container used in the present embodiments is a PET container made from polyethylene terephthalate resin (PET resin manufactured by Nihon Yunipet (Inc.), type RT553) having a capacity of 500 ml, a container height of 200 mm, a container body portion diameter of 71.5 mm, a mouth portion opening inner diameter of 21.74 mm, a mouth portion opening outer diameter of 24.94 mm, and a container body portion thickness of 0.3 mm. The oxygen permeability of the container was measured at 23°C using an Oxtran 2/20 manufactured by Modem Control Company. As for the DLC film thickness, a Si wafer was applied to the inner surface of the container in advance, masking was carried out by tape, and after covering with a DLC film, the masking was removed, and the film thickness was measured by a contour measuring device DEKTAK3 made by Veeco Company. The amount of flake-like dust adhering to the source gas inlet pipe was determined by stripping dust from the source gas inlet pipe, and measuring the weight by an electronic scale (UMT2 manufactured by Mettler Company). The amount of adhered film-like dust was determined by calculating the difference in weight of the entire gas inlet pipe before and after repeated film formations (using an R300S manufactured by Sartorius Company). The coloration was measured using a Hitachi spectrophotometer U-3500.

<u>Examination of Oxygen Barrier Property</u>

<u>Specific Embodiment 1</u>

A DLC film was formed using the manufacturing apparatus of Fig. 2. A mouth side electrode having an annular portion was provided 25 mm directly above the container opening. The film forming method followed the manufacturing method described in the embodiments. The source gas inlet pipe used a tube made from fluororesin. However, the film forming conditions were as follows. The pressure inside the pressure-reducing chamber was reduced from an open system to a pressure of 4 Pa or lower. Then, the flow rate of the introduced source gas was set at 40 ml/min. The concentration of source gas became fixed, and stabilization at 8 ~ 10 Pa was carried out by balancing the controlled gas flow rate and the exhaust capacity. Then, a high frequency (13.56 MHz) at 400 W was applied for 2 seconds. In this way, a DLC film coated plastic container having an inner wall surface coated with a DLC film was manufactured. This formed Specific Embodiment 1. Further, the average film thickness of the DLC film (at the neck portion) was 63 nm.

Specific Embodiment 2

A DLC film was formed in the same way as Specific Embodiment 1 except for the mouth side electrode having an annular portion provided directly above the container opening, and this formed Specific Embodiment 2. Further, the average film thickness of the DLC film (at the neck portion) was 59 nm.

Comparative Example 1

Using the same type of apparatus as that having the prior art type of internal electrode shown in Fig. 8, a DLC film was formed in the same way as Specific Embodiment 1 except for the fact that an internal electrode was used in place of the mouth side electrode. Further, the average film thickness of the DLC film (at the neck portion) was 64 nm.

Table 1 shows the oxygen permeability of Specific Embodiment 1, Specific Embodiment 2 and Comparative Example 1. From Table 1, it is clear that the DLC film coated plastic container manufactured by the apparatus having an internal electrode and the DLC film coated plastic container manufactured by the apparatus having a mouth side electrode which is the apparatus according to the present invention have roughly the same oxygen barrier property. Further, even when the apparatus of Fig. 1 was used in place of the apparatus of Fig. 2 for Specific Embodiment 1, the oxygen barrier property was the same level. Further, even when an apparatus in which the shape of the inner wall of the container side electrode 3 is similar to the external shape of the container like that of the apparatus of Fig. 1 was used for Specific Embodiment 2, the oxygen barrier property was the same level. In Table 1, pkg is an abbreviation for package (container).

(Table 1)

| Sample No. | Structure of Facing Electrode | Oxygen Permeability (cc/pkg/day) | Comparison for PET | Comparison with Prior Art Technology |
|---|---|---|---|---|
| Specific Embodiment 1 | SUS Tube(Mouth side electrode 25mm directly above container) | 0.0044 | 12 | 0.9 |
| Specific Embodiment 2 | SUS Tube(Mouth side electrode directly above container) | 0.0039 | 14 | 1.0 |
| Comparative Example 1 | SUS Internal electrode inserted inside container | 0.0039 | 14 | 1.0 |
| Mesurement Data: 23°C 1 atm, data after 19 hours from the start of mesurement | | | | |

Examination of Amount of Adhered Dust

Specific Embodiment 3

A DLC film was formed using the manufacturing apparatus of Fig. 4. A mouth side electrode having a tubular portion was provided 25 mm directly above the container opening. Further, the end of the tubular portion was equipped with splicing means made from SUS for supporting the source gas inlet pipe. This splicing means formed the end of the tubular portion. The film forming method followed the manufacturing method described in embodiments. The film forming conditions were the same as those for Specific Embodiment 1, and this formed Specific Embodiment 3. Further, the average film thickness of the DLC film (at the neck portion) was 64 nm.

Comparative Example 2

Using the same type of apparatus as that having the prior art type of internal electrode shown in Fig. 8, a DLC film was formed in the same way as Specific Embodiment 1 except for the fact that an internal electrode was used in place of the mouth side electrode. Further, the average film thickness of the DLC film (at the neck portion) was 64 nm.

Table 2 shows the amount of adhered dust adhering to the mouth side electrode of Specific Embodiment 3 and the amount of adhered dust adhering to the internal electrode of Comparative Example 2. From Table 2, it is clear that the amount of adhered dust of Specific Embodiment 3 is reduced to approximately 1/10 of Comparative Example 2. Further, the adhered dust in Specific Embodiment 3 was film-like dust which does not fall off, and this solved the problem of contamination inside the container. Further, even when the number of discharges was repeated 10,000 times under the conditions of Specific Embodiment 3, destabilization of the plasma discharge did not occur. Destabilization of the plasma discharge occurred when the number of discharges was repeated 862 times under the conditions of Comparative Example 2. Accordingly, in contrast with the internal electrode type apparatus, it is clear that the apparatus according to the present invention is superior with regard to dust.

(Table 2)

| Table:Comparison of amount of dust adhering to source gas inlet pipe depending on DLC film formation time. | | | | |
|---|---|---|---|---|
| | Type of gas inlet pipe | Amount of flake-like dust adherence (mg) | Amount of film-like dust adherence(mg) | Comparison of amount of film-like dust adherence |
| Specific Embodiment 3 | Fluororesin | ..... | 3.2 | 0.12 |
| Comparative Example 2 | SUS Internal electrode | 1.2 | 26.0 | 1.00 |
| *1:Each film formation was carried out 15 times. *2:Flake-like dust was black or blackish brown, and was light enough to be blown away. Becuause this forms a quality problem when falling inside container, a cleaning process needs to be added to remove such dust. | | | | |

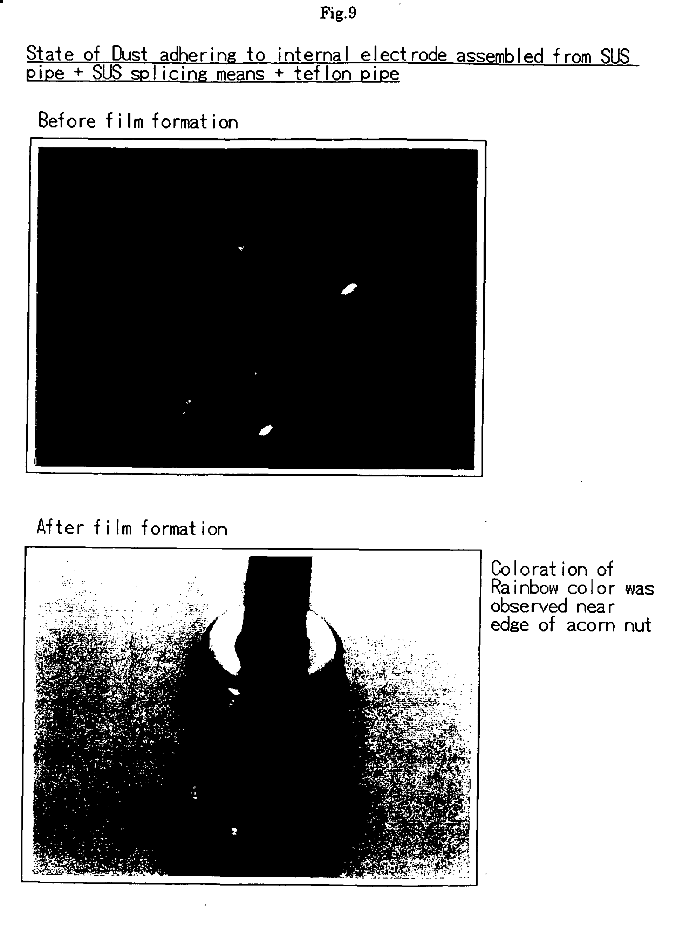

The amount of dust adhering to the mouth side electrode in Specific Embodiment 1 after film formation is smaller compared to the amount of dust adhering to the internal electrode in Comparative Example 1 after film formation. Fig. 9 shows the state of dust adhering to the mouth side electrode in Specific Embodiment 3 by comparison before and after film formation. "After film formation" is the case where film formation is repeated 15 times. In any case, the amount of adhered dust after film formation is small.

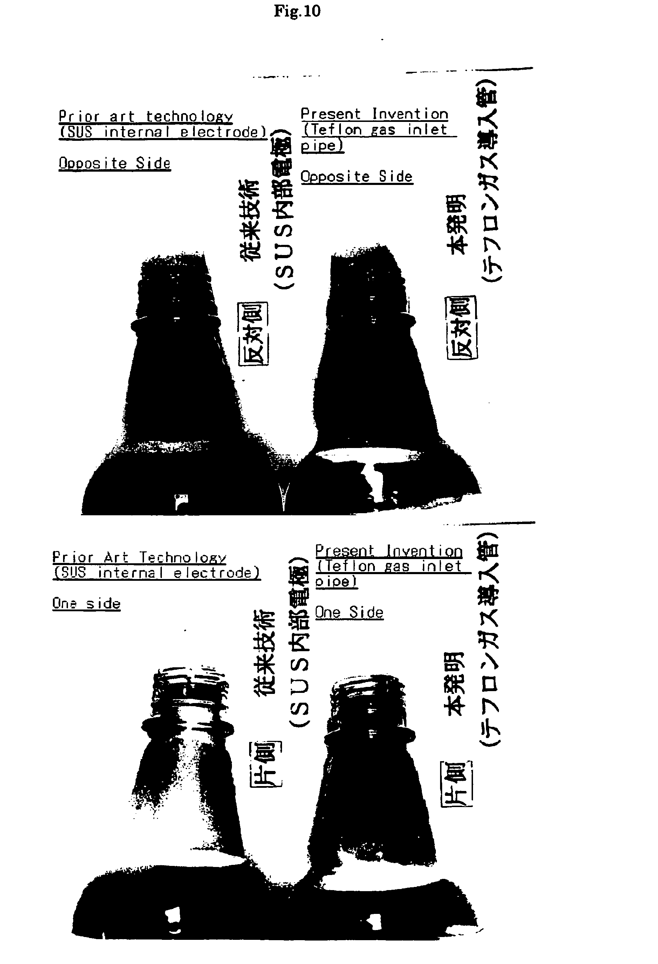

Further, Fig. 10 shows pictures showing a comparison of a DLC film coated plastic container in the case where film formation is repeated 15 times in the same container under the conditions of Specific Embodiment 1 and a DLC film coated plastic container in the case where film formation is repeated 15 times in the same container under the conditions of Comparative Example 1. One side in the drawings refers to one side of the container, and the opposite side refers to the back portion of the one side. By referring to these two pictures, it is possible to make observations around the entire container side surface. According to Fig. 10, in contrast with the large irregularities (coloration state) of the DLC film at the neck portion of the container (mentioned as prior art technology) undergoing film formation 15 times under the conditions of Comparative Example 1, the irregularities (coloration state) of the DLC film at the neck portion in the container (present invention) undergoing film formation 15 times under the conditions of Specific Embodiment 1 were small. In order to quantize these results, the coloration (b* value) of the neck portion was measured for each container of Specific Embodiment 1 and Comparative Example 1 in a clockwise revolution of 360° with respect to the front of the apparatus forming 0°, namely, one revolution along the circumferential direction of the container side surface. In this way, it is possible to judge color irregularities. The b* value is the color difference of JISK 7105-1981, and is calculated by Equation 1 from the tristimulus values X, Y and Z.

## Equation 1

$$b* = 200[(Y/Y_0)^{1/3} - (Z/Z_0)^{1/3}]$$

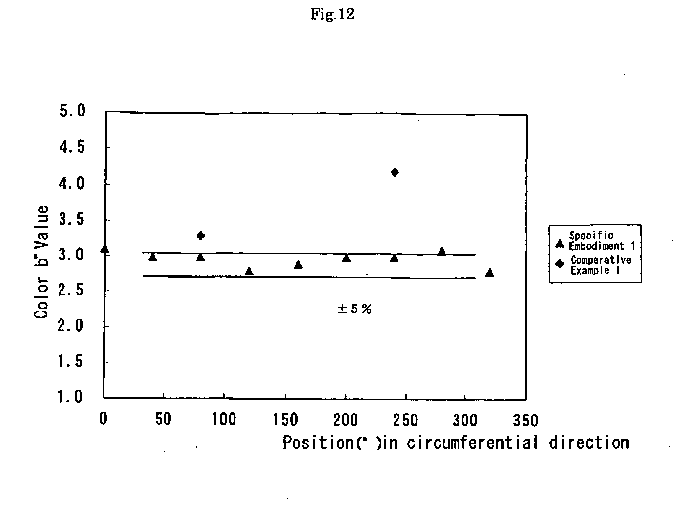

A U-3500 Model automatic recording spectrophotometer manufactured by Hitachi provided with a 60Φ integrating sphere attached apparatus (for infrared near visible infrared) manufactured by the same company was used. An ultrahigh sensitivity photomultiplier (R928: for visible ultraviolet) and a cooling type PbS (for the near infrared region) were used as a detector. As for the measurement wavelengths, the transmittance was measured in the range from 240nm to 840nm. By measuring the transmittance of the PET container, it is possible to calculate the transmittance measurement of only the DLC film, but the b* value of the present embodiments as is shows a calculation in a form that includes the absorptance of the PET container. These results are shown in Fig. 12. From Fig. 12, the b* value of Specific Embodiment 1 over the entire surface 360° around the container neck portion was 2.5 ~ 3.0, and it was possible to improve color irregularities. On the other hand, as is understood from the fact that the b* value of Comparative Example 1 had widespread values of 3.5 ~ 4.5, the color irregularities in the circumferential direction of the container side surface were large. Accordingly, the apparatus of the present invention makes it possible to manufacture a DLC film coated plastic container having small DLC film distribution irregularities in the circumferential direction of the container side surface.

Further, the same results were obtained even when the apparatus of Fig. 3 was used in place of the apparatus of Fig. 4 in Specific Embodiment 3.

From the specific embodiments, it was understood that the apparatus according to the present invention can stabilize plasma discharge at a level which ensures the same oxygen barrier property as that of the prior art, and makes it possible to prevent the adherence of dust on the mouth side electrode. Accordingly, the apparatus according to the present invention has good productivity in manufacturing plastic containers having a superior gas barrier property, and can operate at a high operation rate. Further, the distribution irregularities of the DLC film in the circumferential direction of the container side surface are small.

**Claims**

1.  An apparatus for manufacturing a DLC film coated plastic container, comprising:

    a container side electrode which forms one portion of a pressure-reducing chamber which houses a plastic container, and a mouth electrode arranged above the opening of said plastic container;
    wherein said container side electrode and said mouth side electrode are made to face each other via an insulating body which forms a portion of said pressure-reducing chamber, source gas supply means which supply a source gas that is converted to plasma for coating the inner wall surface of said plastic container with a diamond like carbon (DLC) film includes a source gas inlet pipe formed from an insulating material provided in said pressure-reducing chamber to introduce said source gas supplied to said pressure-reducing chamber to the inside of said plastic container, exhaust means which exhaust gas inside said pressure-reducing chamber from above the opening of said plastic container are provided, and high frequency supply means which supply a high frequency is connected to said container side electrode.

2.  The apparatus for manufacturing a DLC film coated plastic container described in Claim 1, wherein said mouth side electrode is equipped with an annular portion having an inner hole diameter roughly the same as the opening diameter of said plastic container, and the opening of the end of said annular portion is aligned coaxially with respect to the opening of said plastic container and arranged near the opening of said plastic container.,

3.  The apparatus for manufacturing a DLC film coated plastic container described in Claim 1, wherein said mouth side electrode is formed to have a tubular portion which hangs down from the top portion of said pressure-reducing chamber to a position above the opening of said plastic container, said source gas supplied by said source gas supply means is introduced inside said tubular portion, and the end of said tubular portion is connected to said source gas inlet pipe.

4.  The apparatus for manufacturing a DLC film coated plastic container described in Claim 1, 2 or 3, wherein the mouth side electrode described in Claim 1, the end of the annular portion described in Claim 2 or the end of the tubular portion described in Claim 3 makes contact with a gas flow formed from a position near the opening of said plastic container to an exhaust port of said pressure-reducing chamber by the operation of said exhaust means.

5.  The apparatus for manufacturing a DLC film coated plastic container described in Claim 1, 2, 3 or 4, wherein said source gas inlet pipe is formed from a resin material such as fluororesin or the like having an insulating property and heat resistance sufficient to endure plasma or is formed from a ceramic material such as alumina or the like having an insulating property.

6. The apparatus for manufacturing a DLC film coated plastic container described in Claim 1, 2, 3, 4 or 5, wherein said source gas inlet pipe is arranged to be freely inserted to and removed from a deep position reaching the bottom portion from the body portion through the opening of said plastic container.

7. The apparatus for manufacturing a DLC film coated plastic container described in Claim 1, 2, 3, 4, 5 or 6, further comprising source gas inlet pipe insertion/removal means which places said source gas inlet pipe in an inserted state inside said plastic container when said source gas is introduced, and places said source gas inlet pipe in a removed state from said plastic container when plasma is generated.

8. The apparatus for manufacturing a DLC film coated plastic container described in Claim 1, 2, 3, 4, 5, 6 or 7, wherein said plastic container is a beverage container.

**Patentansprüche**

1. Vorrichtung zur Herstellung eines mit einem DLC-Film beschichteten Kunststoffbehälters, mit:

einer behälterseitigen Elektrode, die einen Abschnitt einer Druckminderungskammer bildet, in der ein Kunststoffbehälter aufgenommen ist, und einer oberhalb der Öffnung des Kunststoffbehälters angeordneten Öffnungselektrode,
bei der die behälterseitige Elektrode und die öffnungsseitige Elektrode so ausgeführt sind, daß sie einander über einen Isolierkörper gegenüberliegen, der einen Abschnitt der Druckminderungskammer bildet, Quellgaszuführmittel, die ein Quellgas zuführen, das zur Beschichtung der Innenwandfläche des Kunststoffbehälters mit einem Film aus diamantartigem Kohlenstoff (DLC-Film) in Plasma überführt wird, ein Quellgaseinlaßrohr aufweisen, das aus einem in der Druckminderungskammer vorgesehenen Isoliermaterial gebildet ist, um das der Druckminderungskammer zugeführte Quellgas in das Innere des Kunststoffbehälters einzuleiten, Ausströmmittel vorgesehen sind, die Gas in der Druckminderungskammer von oberhalb der Öffnung des Kunststoffbehälters ausströmen lassen, und ein eine Hochfrequenz zuführendes Hochfrequenzzuführmittel an die behälterseitige Elektrode angeschlossen ist.

2. Vorrichtung zur Herstellung eines mit einem DLC-Film beschichteten Kunststoffbehälters gemäß Anspruch 1, bei der die öffnungsseitige Elektrode mit einem ringförmigen Abschnitt versehen ist, der einen Innenlochdurchmesser hat, der etwa dem Öffnungsdurchmesser des Kunststoffbehälters entspricht, und die Öffnung des Endes des ringförmigen Abschnitts koaxial bezüglich der Öffnung des Kunststoffbehälters ausgerichtet und nahe der Öffnung des Kunststoffbehälters angeordnet ist.

3. Vorrichtung zur Herstellung eines mit einem DLC-Film beschichteten Kunststoffbehälters gemäß Anspruch 1, bei der die öffnungsseitige Elektrode so ausgebildet ist, daß sie einen rohrförmigen Abschnitt hat, der von dem oberen Abschnitt der Druckminderungskammer bis zu einer Stelle oberhalb der Öffnung des Kunststoffbehälters herabhängt, das von dem Quellgaszuführmittel zugeführte Quellgas in den rohrförmigen Abschnitt eingeleitet wird und das Ende des rohrförmigen Abschnitts mit dem Quellgaseinlaßrohr verbunden ist.

4. Vorrichtung zur Herstellung eines mit einem DLC-Film beschichteten Kunststoffbehälters gemäß Anspruch 1, 2 oder 3, bei der die öffnungsseitige Elektrode gemäß Anspruch 1, das Ende des ringförmigen Abschnitts gemäß Anspruch 2 oder das Ende des rohrförmigen Abschnitts gemäß Anspruch 3 mit einem von einer Stelle nahe der Öffnung des Kunststoffbehälters aus bis zu einer Ausströmöffnung der Druckminderungskammer durch den Betrieb der Ausströmmittel gebildeten Gasstrom in Kontakt gelangt.

5. Vorrichtung zur Herstellung eines mit einem DLC-Film beschichteten Kunststoffbehälters gemäß Anspruch 1, 2, 3 oder 4, bei der das Quellgaseinlaßrohr aus einem Harzmaterial wie etwa Fluorharz oder dergleichen, dessen Isolierfähigkeit und Wärmebeständigkeit ausreichen, um Plasma standzuhalten, oder aus einem Keramikmaterial wie etwa Aluminiumoxid oder dergleichen gebildet ist, das eine Isolierfähigkeit aufweist.

6. Vorrichtung zur Herstellung eines mit einem DLC-Film beschichteten Kunststoffbehälters gemäß Anspruch 1, 2, 3, 4 oder 5, bei der das Quellgaseinlaßrohr so angeordnet ist, daß es durch die Öffnung des Kunststoffbehälters frei in eine tiefe Stellung, in der es vom Körperabschnitt aus den Bodenabschnitt erreicht, eingeführt und aus dieser entfernt werden kann.

**7.** Vorrichtung zur Herstellung eines mit einem DLC-Film beschichteten Kunststoffbehälters gemäß Anspruch 1, 2, 3, 4, 5 oder 6, die ferner eine Einrichtung zur Einführung/Entfernung des Quellgaseinlaßrohres umfaßt, die das Quellgaseinlaßrohr in einen in den Kunststoffbehälter eingeführten Zustand versetzt, wenn das Quellgas eingeleitet wird, und das Quellgaseinlaßrohr in einen aus dem Kunststoffbehälter entfernten Zustand versetzt, wenn Plasma erzeugt wird.

**8.** Vorrichtung zur Herstellung eines mit einem DLC-Film beschichteten Kunststoffbehälters gemäß Anspruch 1, 2, 3, 4, 5, 6 oder 7, bei der der Kunststoffbehälter ein Getränkebehälter ist.

**Revendications**

**1.** Dispositif de fabrication d'un conteneur en matière plastique recouvert d'un film de DLC, comprenant:

une électrode côté conteneur, qui forme une portion d'une chambre de réduction de pression qui renferme un conteneur en matière plastique, et une électrode d'embouchure agencée au-dessus de l'ouverture du conteneur en matière plastique ;
dans lequel l'électrode côté conteneur et l'électrode côté embouchure sont réalisées pour se faire face mutuellement par l'intermédiaire d'un corps isolant qui forme une portion de la chambre de réduction de pression, des moyens d'amenée de gaz de source, qui amènent un gaz de source qui est converti en un plasma pour revêtir la surface intérieure de paroi du conteneur en matière plastique avec un film de carbone amorphe diamantin (DLC), comprennent un tuyau d'admission de gaz de source formé à partir d'un matériau isolant, prévu dans la chambre de réduction de pression pour introduire le gaz de source amené à la chambre de réduction de pression à l'intérieur du conteneur en matière plastique, il est prévu des moyens d'écoulement qui font écouler du gaz à l'intérieur de la chambre de réduction de pression depuis le dessus de l'ouverture du conteneur en matière plastique, et des moyens d'amenée d'une haute fréquence, qui amènent une haute fréquence, sont connectés à l'électrode côté conteneur.

**2.** Dispositif de fabrication d'un conteneur en matière plastique recouvert d'un film de DLC décrit dans la revendication 1, dans lequel l'électrode côté embouchure est munie d'un tronçon annulaire ayant un diamètre intérieur de trou environ égal au diamètre d'ouverture du conteneur en matière plastique, et l'ouverture de l'extrémité du tronçon annulaire et coaxialement alignée avec l'ouverture du conteneur en matière plastique et agencée à proximité de l'ouverture du conteneur en matière plastique.

**3.** Dispositif de fabrication d'un conteneur en matière plastique recouvert d'un film de DLC décrit dans la revendication 1, dans lequel l'électrode côté embouchure est formée de telle sorte qu'elle présente un tronçon tubulaire qui est suspendu depuis la portion de sommet de la chambre de réduction de pression jusqu'à une position au-dessus de l'ouverture du conteneur en matière plastique, le gaz de source amené par les moyens d'amenée de gaz de source est introduit à l'intérieur du tronçon tubulaire, et l'extrémité du tronçon tubulaire est connectée au tuyau d'admission de gaz de source.

**4.** Dispositif de fabrication d'un conteneur en matière plastique recouvert d'un film de DLC décrit dans la revendication 1, 2 ou 3, dans lequel l'électrode côté embouchure décrite dans la revendication 1 ou l'extrémité du tronçon annulaire décrit dans la revendication 2 ou l'extrémité du tronçon tubulaire décrit dans la revendication 3 établit un contact avec un flux de gaz formé depuis une position proche de l'ouverture du conteneur en matière plastique vers un orifice d'écoulement de la chambre de réduction de pression lors du fonctionnement des moyens d'écoulement.

**5.** Dispositif de fabrication d'un conteneur en matière plastique recouvert d'un film de DLC décrit dans la revendication 1, 2 ,3 ou 4, dans lequel le tuyau d'admission de gaz de source est réalisé dans un matériau de résine tel que de la résine fluorée ou similaire ayant des propriétés isolantes et une résistance à la chaleur qui est suffisance pour résister au plasma, ou est réalisé en un matériau céramique tel que de l'alumine ou similaire ayant des propriétés isolantes.

**6.** Dispositif de fabrication d'un conteneur en matière plastique recouvert d'un film de DLC décrit dans la revendication 1, 2, 3, 4 ou 5, dans lequel le tuyau d'admission de gaz de source est agencé de telle sorte qu'il est inséré librement à une position profonde, de laquelle il peut être dégagé et laquelle atteint la portion de fond depuis la portion de corps à travers l'ouverture du conteneur en matière plastique.

**7.** Dispositif de fabrication d'un conteneur en matière plastique recouvert d'un film de DLC décrit dans la revendication 1, 2, 3, 4, 5 ou 6, comprenant en outre des moyens d'insertion/de dégagement du tuyau d'admission de gaz de source qui mettent le tuyau d'admission de gaz de source dans un état d'insertion à l'intérieur du conteneur en matière plastique lorsque le gaz de source est introduit, et qui mettent le tuyau d'admission de gaz de source dans un état de dégagement hors du conteneur en matière plastique lorsque le plasma est produit.

**8.** Dispositif de fabrication d'un conteneur en matière plastique recouvert d'un film de DLC décrit dans la revendication 1, 2, 3, 4, 5, 6 ou 7, dans lequel le conteneur en matière plastique est un conteneur de boisson.

EP 1 508 630 B1

Fig.1

16

## Fig.2

Fig.3

To Vent ↑

To Duct ↑

18

16   17

Source Gas

Exhaust
Pump

40

5a

5

5b

4

20   19

21

8

6

7

9

2

3

1

8

RF Power
Source

Matching
Box

9a

13   12

14

Fig.4

Fig.5

To Vent ↑

18

16    17

Source Gas

↑ To Duct

Exhaust Pump

20      19

21

40

5

4

8

6

2

3

1

8

Matching Box

RF Power Source

13      12

14

Fig.6

To Vent ↑

To Duct

18

16    17

Source Gas

Exhaust
Pump

23

40

5

11

9

4

10

9a

8

6

20    19

21

RF Power
Source

Matching
Box

7

1

3

2

8

13    12

14

Fig.7

To Vent ↑

Source Gas

18

16  17

↑To Duct

Exhaust Pump

40

5a

5

5b

4

9

20   19

21

9a

8

6

7

2

3

1

8

RF Power Source

Matching Box

13   12

14

Fig.8

Exhaust

Fig.9

State of Dust adhering to internal electrode assembled from SUS pipe + SUS splicing means + teflon pipe

Before film formation

After film formation

Coloration of Rainbow color was observed near edge of acorn nut

## Fig.10

Prior art technology
(SUS internal electrode)

Opposite Side

Present Invention
(Teflon gas inlet
pipe)

Opposite Side

従来技術
（ＳＵＳ内部電極）

反対側

本発明
（テフロンガス導入管）

反対側

Prior Art Technology
(SUS internal electrode)

One side

Present Invention
(Teflon gas inlet
pipe)

One Side

従来技術
（ＳＵＳ内部電極）

片側

本発明
（テフロンガス導入管）

片側

Fig.11

Mouth
Portion

Neck
Portion

Shoulder
Portion

Body
Portion

Bottom Portion

Fig.12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI853117 B